# EUROPEAN PATENT APPLICATION

(11) **EP 2 131 500 A2**
(43) Date of publication of application: **09.12.2009**
(21) Application number: 08168664.4
(22) Date of filing: 07.11.2008
(51) Int. Cl.: H03L 7/26, G04F 5/14

(54) **Atomic beam tube with counter propagating optical or atomic beams**

(30) Priority: 02.06.2008 US 129039 P
(71) Applicant: SEPA - Sistemi Elettronici Per Automazione S.P.A., 10151 Torino TO (IT); AccuBeat Ltd., 91450 Jerusalem (IL)
(72) Inventor: Levi, Filippo, 10135, Torino (IT); Stern, Avinoam, 91450, Jerusalem (IL)
(74) Representative: Buzzi, Franco

(57) **Abstract**

An atomic beam tube for frequency standard which employs either counter propagating optical beams or counter propagating atomic beams and Coherent Population Trapping (CPT) is disclosed. Atoms selected from the group consisting of the alkali metal family (Cesium, Rubidium, Potassium, Sodium and Lithium) are emitted from one or two sources to form a single or double atomic beams. The atoms interact with the optical beams at two crossing points. The optical beams are generated by a laser and are modulated at half the hyperfine frequency. The optical beam is splitted into two counter propagating beams in round paths which interact with the atomic beam at two interaction regions. The interaction with the light causes the atoms to enter a CPT state. A dark line in the fluorescence at the second crossing is used to lock an RF oscillator to the atomic hyperfine transition.

## Description

### Field of the invention

The present invention relates generally to atomic standards and a method of providing a frequency and/or time based on an atomic standard, and more particularly to atomic frequency and/or time standards and methods employing a beam tube.

### State of the prior art

The following is a list of prior publications generally related to the field of the present invention:
1. J. Vanier and C. Audoin, The Quantum Physics of Atomic Frequency Standards (Institute of Physics Publishing, Bristol, UK, 1989)
2. R. Lutwak, D. Emmons, R. M. Garvey, and P. Vlitas , Opticaly-Pumped Cesium Beam Frequency Standard for GPS-III, Proceedings of the 33rd Annual Precise Time and Time Interval Systems Applications Meeting Long Beach, California November 27-29, 2001
3. I. Pascaru, Atomic frequency standard using optical pumping for state preparation and magnetic state selection of atoms, US patent 5107226
4. J. Vanier, Atomic clocks based on coherent population trapping: a review, Appl. Phys. B 81, 441-442, 2005
5. J. Vanier, Atomic frequency standard based on coherent state preparation, US patent 6255647, 1999
6. N. Dimarcq, S. Guerandel, T. Zanon, D. Holleville, Method For Modulating An Atomic Clock Signal With Coherent Population Trapping, US Application number: 10/594,575, 2005
7. Y.Y.Jau and W. Happer, Method and system for operating a laser self-modulated at alkali-metal atom hyperfine frequency, US Application No. 11284064 2008
8. A. Godone, F. Levi and S. Micalizio, Subcollisional linewidth observation in the coherent-population-trapping Rb maser Phys. Rev. A 65, 031804 (2002)

Current commercially atomic frequency primary standards typically employ a Cesium beam tube to control the frequency of a crystal-controlled oscillator. Such commercially-available units have a traditional Cesium beam tube configuration. The construction and operation of traditional Cesium beam tube atomic frequency standards is described in reference 1.

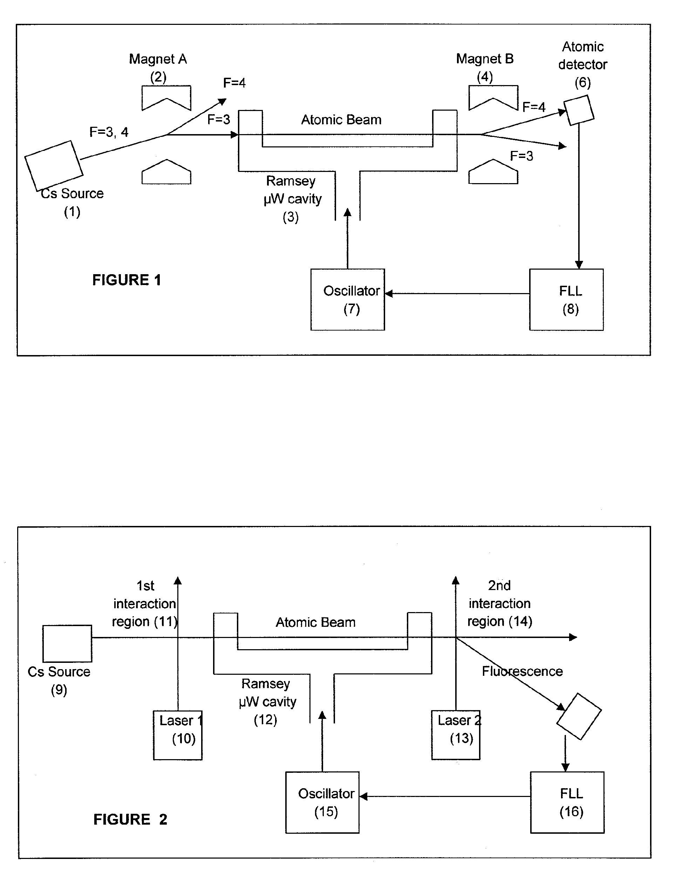

FIG. 1 of the drawings herein shows schematically a traditional Cesium ("Cs") beam frequency standard 10 which includes a Cs source (oven) (1), a state preparation "A" magnet (2), a Ramsey microwave cavity (3), a state selection "B" magnet (4), and a detector (5). In the traditional Cs beam standard, cesium atoms emitted from oven (1) are directed into the gap of the "A" magnet (2). Due to the large gradient of the "A" magnet (2), the cesium atoms in the F=3 and F=4 states are deflected in different directions. In the particular arrangement shown in FIG. 1, the "A" magnet (2) deflects the cesium atoms in the F=3 state to and through the a microwave cavity (3) to the "B" magnet (4). The RF magnetic field in cavity (3) created by microwave oscillations causes some of the Cs atoms in cavity (4) undergo a transition to the F=4 state. The atoms that have undergone a transition from F=3 to F=4 in the cavity (3) are deflected towards the atomic detector (4) by the "B" magnet (5).

The output of detector (6) is used to control oscillator (7) by means of FLL circuit (8). The detection signal on output of detector (6) varies in accordance with the quantity of Cs atoms that have undergone a transition in the cavity (4), and functions as an error signal for controlling the frequency of oscillator (7).

The Ramsey microwave cavity (3) is composed of two symmetrical arms and an in-between free zone. The width of detected line and the resultant stability of the frequency standard is proportional to the flying time of the atoms in the free zone; the longer the free zone the better the stability.

An Optical Cs beam tube atomic standard employing optical pumping for state preparation and optical pumping for detection has been the subject of investigation for many years now. Such optically pumped Cs beam tube standards employ optical state selection and state detection which replace the "A" magnet the "B" magnet, as well as a Ramsey microwave cavity and oscillator similar to the ones used in the classical Cs beam tube standard described above. In the 1^{st} interaction region, optical pumping creates a hyperfine population difference. The resonance phenomenon is detected through fluorescent light variations as a function of the microwave frequency in a second interaction region. This fluorescent light variation, which is a direct measure of the number of Cs atoms which have undergone a transition, is detected and used to control the frequency of the microwave oscillations. A number of different pumping schemes are possible which may prepare cesium atoms Such schemes are well known and described in the literature (see references 1- 3).

As far as it is known, such optical beam tube standards are either of the laboratory-type or are in development, and are not commercially available. See references 1-3.

FIG. 2 is a schematic diagram of an optical beam tube standard. Similar to the traditional Cs beam standard, the optical beam tube standard uses an oscillator (15) and a microwave cavity (12); however, in the 1^{st} interaction region (11) , and in the second interaction region (14), laser sources (10) and (13) are employed for optical pumping rather than "A" and "B" magnets for state selection. The Cs atoms emitted from source (9) are optically pumped by laser (10) into a hyperfine state in the the 1^{st} interaction region (11).

The Cs atoms then enter Ramsey cavity (12). Again the RF magnetic field in cavity (12) causes some of the Cs atoms passing through cavity 16 to undergo a transition as a result of resonance phenomenon. After leaving cavity (12), Cs atoms enter the 2^{nd} interaction region (14), where the resonance phenomenon in cavity (12) is detected through fluorescent light variations as a function of the microwave frequency. This is accomplished by optically pumping Cs atoms back to the hyperfine state, which generates photons and the fluorescence described above.

Again, the output of the (photo) detector (17) is used to control oscillator (15) by means of FLL circuit (16). The detection signal on output of detector (17) varies in accordance with the quantity of Cs atoms that have undergone a transition in the cavity (12), and functions as an error signal for controlling the frequency of oscillator (15).

Coherent Population Trapping (CPT) is a phenomenon which is being used since few years to make atomic clocks which are based on vapor cells without using the traditional microwave cavity. CPT state occurs when an alkali atom (for example) is subject to two optical fields with wavelengths that correspond approximately to the D1 or to the D2 transitions of the said alkali atom and where the frequency difference between the two optical wavelengths matches the hyperfine 0-0 transition. Under these conditions the atoms are trapped in a superposition state of the two hyperfine levels and cease to absorb or emits radiation, i.e., they become transparent to the said optical radiation and in addition one observe a dark line in their fluorescence. For more details see references 3-7. To our knowledge CPT has not been used in atomic standards based on atomic beam.

### Summary of the invention

The invention concerns an atomic beam tube that uses single or double atomic beam combines with single or double optical beams and where the Coherent Population Trapping (CPT) phenomenon is employed. Two main configurations are proposed, which are set forth in claims 1 and 2, respectively and will be disclosed in details in the following. These are described in the following two sections.

### Brief description of the drawings

In the drawings:
FIG. 1 shows schematically a traditional Cesium ("Cs") beam frequency standard
FIG. 2 is a schematic diagram of an optical beam tube standard
FIG. 3 is a schematic diagram of a first embodiment of the invention, and
FIG. 4 is a schematic diagram of a second embodiment of the invention

### Detailed description of the invention

### 1. Counter propagating optical beams, single one-way atomic beam

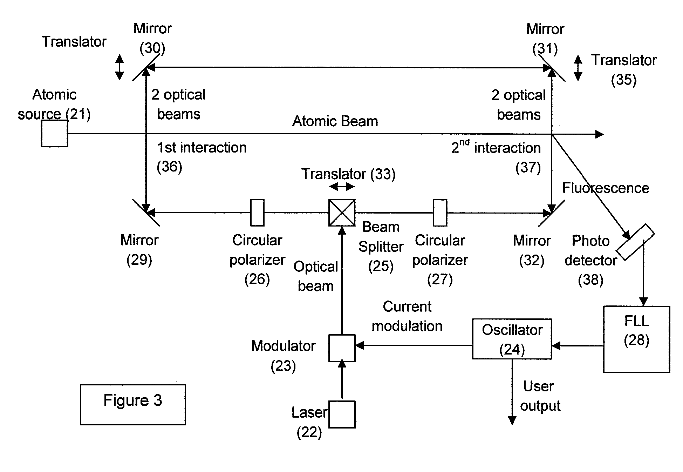

In this configuration a round optical beam configuration is employed, such as shown in Figure 3. An atomic source (21) generates a collimated atomic beam inside a vacuum envelope (not shown in the figure). A laser (22) emits optical beam at a wavelength which corresponds to the D1 or the D2 transition of the used alkali atom (for Cs D1 wavelength is 894.35 nm and D2 wavelength is 852.11nm). The optical beam is modulated by a modulator (23) at a frequency around half the hyperfine transition frequency of the used alkali atom. The said modulation generates two sidebands separated by the hyperfine 0-0 transition frequency (for Cs the hyperfine frequency is around 9.2GHz). The modulation frequency is generated by an Oscillator (24). The optical beam is then split into two symmetrical left and right beams by a beam splitter (25). Each beam is transmitted through a circular polarizer (a quarter-lambda plate). The said left beam is circulated right wise and the right beam is circulated left wise by means of 4 mirrors (29-32) in such a way that it crosses the atomic beam at two interaction regions (36) and (37) separated by (for example) 20 cm. The 1^{st} interaction region (36) is closer to the atomic source and the 2^{nd} interaction region (37) is further away from the atomic source. The said mirrors and the said splitter are mounted on tilters and translators (33-35) to enable adjustments of optical beam lengths and angles in order to achieve a given set of the following conditions:
(a) the optical beams cross the atomic beam perpendicularly
(b) the counter propagating beams overlap
(c) the counter propagating beams have the same or opposite circular polarization
(d) the two counter propagating beams have equal microwave phases at each interaction region (the microwave modulation phase is defined by the phase of the frequency difference between the two sidebands that are formed by the microwave modulation)
(e) the microwave phases of the two counter propagating beams at each interaction region differs by 180 degrees
(f) The phase of the resulting net polarization in each interaction zone can be equal or can differ bi 180°.

Finally a photo detector (38) detects the fluorescence emitted by the atoms crossing the said 2^{nd} interaction region. The photo detector output is used by a Frequency-Lock-Loop (FLL) circuit (28) to lock an Oscillator (24) to the CPT dark line which is related to the said hyperfine transition frequency. The said Oscillator (24) also generates an output for the user.

Not shown in the figure are the "C-field" coil that generates a constant homogeneous magnetic field perpendicular to the atomic beam and a set of magnetic shields to shield the atoms from the environmental stray field.
The principles and advantages of this configuration are as follows:
(a) The atoms crossing the 1^{st} interaction region are driven into a CPT state by the optical modulated beam. Than they travel through a dark free zone and cross the second interaction region where they meet the modulated optical beams. When the phase of the precessing atom matches the microwave phases of the modulated optical beams one observes the main central peak in the Ramsey pattern which is formed by the dark fluorescence line. When the phase of the precessing atom is shifted by 180 degrees one observes a valley in the Ramsey pattern. The peak or the valley are used to lock the said oscillator to the atomic hyperfine transition. A key advantage of using the CPT method is that one gets rid of the Ramsey microwave cavity which is used in both the traditional atomic beam standard and in the optical atomic beam standard.
(b) The double circular beams configuration provides numerous advantages which substantially improve the frequency standard performance. It can be shown that:
   a. the configuration of two counter propagating overlapping optical beams at each interaction region cancels the 1^{st} order Doppler shift originating from (small) non-perpendicular component of the optical fields.
   b. the symmetrical double circular optics cancels to a first order (microwave) phase shift caused by asymmetries in the optical paths. Phase shifts cause frequency shift in the frequency standard.
   c. the configuration of two counter-propagating beams with counter circular polarizations pumps almost all atoms into the CPT state between the two hyperfine 0-0 levels, thus increasing the signal to noise to a maximum.
   d. the double circular polarization is insensitive to a first order to misalignment between the two counter propagating beams.
(c) Calculations were performed that show that an Allan Deviation of parts of 1E-13 at an averaging time of 1s is plausible using the proposed invention. This is almost an order of magnitude better then the stability exhibited the current traditional and optical Cesium beam clocks.

### 2. One-way optical beams, two-ways counter-propagating atomic beams

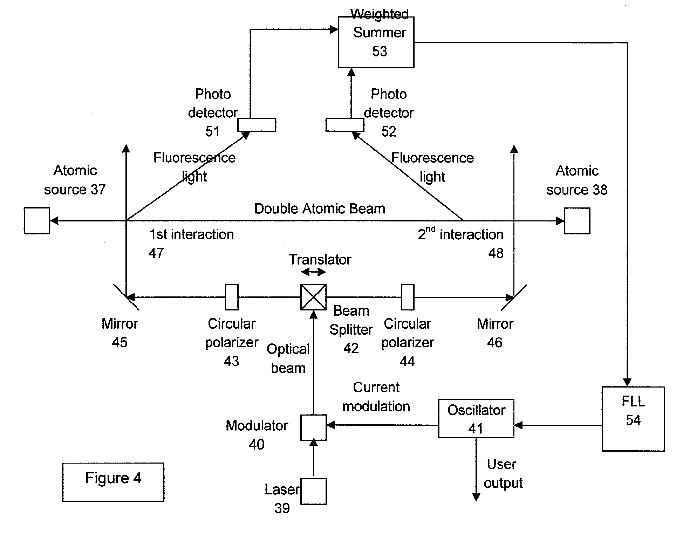

In this configuration a round optical beam configuration is employed, such shown in Figure 4.

Two atomic sources (37, 38) generate two overlapping counter-propagating atomic beams inside a vacuum envelope (not shown in the figure). A laser (39) emits optical beam at a wavelength which corresponds to the D1 or the D2 transition of the used alkali atom (for Cs D1 wavelength is 894.35 nm and D2 wavelength is 852.11nm). The optical beam is modulated by a modulator (40) at a frequency around half the hyperfine transition frequency of the used alkali atom. The said modulation generates two sidebands separated by the hyperfine 0-0 transition frequency (for Cs the hyperfine frequency is around 9.2GHz). The modulation frequency is generated by an Oscillator (41). The optical beam is then split into two symmetrical left and right beams by a beam splitter (42). Each beam is transmitted through a circular polarizer (43-44) (a quarter-lambda plate). The said left beam is circulated right wise and the right beam is circulated left wise by means of 2 mirrors (45-46) in such a way that it crosses the atomic beam at two interaction regions (47) and (48) separated by (for example) 20 cm. In the present configuration the two interaction regions are symmetrical with respect the two atomic sources. The said mirrors and the said splitter are mounted on tilters and translators to enable adjustments of optical beam lengths and angles in order to achieve a given set of the following conditions:
(a) the optical beams cross the double atomic beam perpendicularly.
(b) the microwave phases of the two beams at each interaction region differs by 180 degrees (the microwave modulation phase is defined by the phase of the frequency difference between the two sidebands that are formed by the microwave modulation).
(c) The phase of the resulting net polarization in each interaction zone can be equal or can differ by 180°.

Next two photo detectors (51, 52) detect the fluorescence emitted by the atoms from both interaction regions. The photo detectors outputs are weighted summed by a summer (53) and the sum signal is used by a Frequency-Lock-Loop (FLL) circuit (54) to lock the Oscillator (41) to the CPT dark line. The said Oscillator (41) also generates an output for the user.
Not shown in the figure are the "C-field" coil that generates a constant homogeneous magnetic field perpendicular to the atomic beam and a set of magnetic shields to shield the atoms from the environmental stray field.
The principles and advantages of this configuration are as follows:

In primary frequency standard Cs beam tubes the end to end phase shift is generally evaluated by running alternatively the atomic beam from left to right or from right to left. In this way if there is a phase change between the first and the second Ramsey interaction zone the sign of the shift change and average to zero. Similarly if there is a residual first order Doppler shift due to progressive wave inside the microwave cavity, by changing the speed of the atoms the shift change sign and average to zero.

The idea is to have two counter-propagating atomic beams. This will cause a very high order cancellation of the end-to-end phase shift as well as of the first order Doppler shift.

This idea would probably not be implemented in a magnetically selected beam, because of the need of the hot wire detector. Instead it can surely be implemented in an optically pumped device where the pumping and detection zone are made equal and symmetric. A negative effect in this case is the doubling of the scattered light; a possible source of light shift.

In a device which utilizes CPT beam instead, no change in the optical system is required. A major engineering effort should probably be done in order to guarantee a good retracing of the beams and an efficient way to stop the two beams without interfering with the nozzle.

From the point of view of the signal there will be an increased background florescence in the detection zone because of the transverse pumping process happening in each zone, but there will be aslo two statistically independent signals. Since the main noise contribution will probably came form straight scattering of the laser this will not change.

From the loop point of view the two signal should be considered of the same importance, and the microcontroller should lock the VCO to their average frequency. In this way we zero the end to end and the first order Doppler shift.

A device where the end to end phase shift is compensated by two counter-propagating atomic beams, can be almost considered a Primary frequency standard, because almost all other shift can be evaluated with programmable experiments.

## Claims

1. An atomic beam tube apparatus to be used for a frequency standard, said apparatus comprising:
○ a source of atoms inside a vacuum envelope for generation of an atomic beam selected from the group consisting of the alkali metal family;
○ a system of coils and shields that generates homogeneous magnetic field along the atomic beam;
○ a laser for generating an optical radiation at a wavelength corresponding to the D1 line or the D2 line of the said alkali atom;
○ an optical field modulator for generating a modulated optical beam with two of the sidebands separated by a frequency that matches the hyperfine transition of the said alkali atom;
○ an optical beam-splitter and a set of mirrors to generate from the said modulated optical field two sets of two counter propagating optical beams which cross the atomic beam at two separated points;
○ set of optical linear and circular polarizers to generate counter polarization with for each said two counter propagating beams;
○ set of translators and tilters to adjust the phase of the said modulation at the two said crossing points and to adjust the said crossing angles;
○ set of windows as necessary to transmit light in and out the vacuum envelope, and
○ a set of photodiodes to detect the fluorescence emitted by the atoms at the said crossing regions, wherein the photodiodes output is used to lock an oscillator to the atomic line.

2. An atomic beam tube apparatus to be used for a frequency standard, said apparatus comprising:
○ two opposite sources of atoms inside a vacuum envelope for generation of two counter-propagating atomic beams selected from the group consisting of the alkali metal family;
○ a system of coils and shields that generates homogeneous magnetic field along the atomic beam;
○ a laser for generating an optical radiation at a wavelength corresponding to the D 1 line or the D2 line of the said alkali atom;
○ an optical field modulator for generating a modulated optical beam with two of the sidebands separated by a frequency that matches the hyperfine transition of the said alkali atom;
○ an optical beam-splitter and a set of mirrors to generate from the said modulated optical field two optical beams which cross the atomic beam at two separated points;
○ set of optical linear and circular polarizers to generate counter polarization with for each said two counter propagating beams;
○ set of translators and tilters to adjust the phase of the said modulation at the two said crossing points and to adjust the said crossing angles;
○ set of windows as necessary to transmit light in and out the vacuum envelope
○ light collection system and set of mirrors to collect and direct the fluorescence light emitted from the atoms at the two interaction regions, and
○ a photodiode to detect the said fluorescence to be used as the signal for the atomic standard.

3. The apparatus of claim 1 where the phase shift between the first and the second Ramsey interaction is compensated through a beam reflection, with the proper phase setting so that the microwave equivalent phase of the two beams is the same in the two interaction zones, and the reflected beam phase is also the same.

4. The apparatus of claim 1 where the phase shift between the first and the second Ramsey interaction is compensated through a beam recirculation, with the proper phase setting, so that the microwave equivalent phase of the two beams is the same in the two interaction zones, and the reflected beam phase is also the same.

5. The apparatus of claim 3 where the phase of the reflected beam is shifted by 180 degrees.

6. The apparatus of claim 4 where the phase of the re-circulated beam is shifted by 180 degrees.

7. The apparatus of claims 4 and 6, where the polarizations are set as follows:
1^{st} Ramsey zone σ+σ+
2^{st} Ramsey zone σ+σ+

8. The apparatus of claims 4 and 6, where the polarizations are set as follows:
1^{st} Ramsey zone σ+σ-
2^{st} Ramsey zone σ+σ-

9. The apparatus of claims 4 and 6, where the polarizations are set as follows:
1^{st} Ramsey zone σ+σ-
2^{st} Ramsey zone σ-σ+

10. The apparatus according to claims 1 and 3-9 wherein the said modulation is achieved by modulating the laser current.

11. The apparatus of claims 1 and 3-9 wherein the said modulation is achieved by modulating the laser phase.

12. The apparatus of claims 1 and 3-9 wherein the said two sidebands are obtained by two mode locked lasers.

13. The apparatus of claims 1 and 3-9 wherein the said system of coils and shields are located inside the vacuum envelope.

14. The apparatus of claims 1 and 3-9 wherein the said polarizers, mirrors and translators are located inside the vacuum envelope.

15. The apparatus of claims 1 and 3-9 wherein the said photodiodes are located inside the vacuum envelope.

16. The apparatus of claim 2 where the microwave is induced via the microwave cavity and the optical field is not modulated and is used for pumping and detection only.
